Europäisches Patentamt

European Patent Office

Office européen des brevets

(19)

(11) EP 0 863 613 A1

(12) **EUROPÄISCHE PATENTANMELDUNG**

(43) Veröffentlichungstag:
09.09.1998 Patentblatt 1998/37

(51) Int. Cl.$^6$: **H03K 17/795**

(21) Anmeldenummer: 97102092.0

(22) Anmeldetag: 10.02.1997

(84) Benannte Vertragsstaaten:
AT BE CH DE DK ES FI FR GB GR IE IT LI LU MC NL PT SE

(71) Anmelder:
SIEMENS AKTIENGESELLSCHAFT
80333 München (DE)

(72) Erfinder:
Zierhut, Hermann, Dipl.-Ing.
93073 Neutraubling (DE)

(54) **Optokoppleranordnung**

(57)     Optokoppleranordnung zur Impulsübertragung bei galvanischer Trennung, die in einem Schaltnetzwerk je Übertragungsbereich zumindest einen Optokoppler auf einer Eingangsseite zum Impulsempfang aufweist, und die auf ihrer Ausgangsseite zur Impulsabgabe dem Prinzip nach mit einem Spannungsfall in Serie zum Optokoppler arbeitet. Es ist vorgesehen, daß der Spannungsfall an einem weiteren Optokoppler (ISO 4) in Serie gebildet ist, wobei der Optokoppler (ISO 3) und der weitere Optokoppler (ISO 4) auf der Eingangsseite in einem Schaltkreis (12) angeordnet sind, der über eine Kapazität (C1) zur Ansteuerung, Ansteuerkapazität genannt, an einem Eingangsanschluß (1) angeschlossen ist, wobei zwischen den Optokopplern eine Leitungsverbindung  zu einem weiteren Eingangsanschluß (2) hergestellt ist, und wobei auf der Ausgangsseite zwischen den Optokopplern eine Leitungsverbindung zu einem Ausgangsanschluß (5) hergestellt ist und die Serienschaltung aus den beiden Optokopplern an einer Seite an dem weiteren Aus- gangsanschluß (6) angeschlossen ist und an ihrer anderen Seite mit einer Versorgungsspannung in Ver- bindung steht (Anschluß 7).

FIG 3

EP 0 863 613 A1

**Beschreibung**

Die Erfindung bezieht sich auf eine Optokoppleranordnung zur Impulsübertragung bei galvanischer Trennung, die in einem Schaltnetzwerk je Übertragungsbereich zumindest einen Optokoppler auf einer Eingangsseite zum Impulsempfang aufweist. Übliche Optokoppleranordnungen arbeiten auf der Ausgangsseite zur Impulsabgabe in Serie zum Optokoppler mit zumindest einem Arbeitswiderstand, um Impulse zu bilden.

Um kurze Ausschaltzeiten zu ermöglichen, arbeitet man in der Regel mit niederohmigen Arbeitswiderständen, so daß man verhältnismäßig große Ströme benötigt. Entsprechend muß auch eine Ansteuerschaltung einen entsprechend großen Strom liefern. Beispielsweise benötigt man bei einer Bordnetzspannung von 5 V bei einem Arbeitswiderstand von 100 Ohm einen Strom von 50 mA. In der Praxis ist es schwierig, über eine Fertigungsreihe die Streuung so klein zu halten, daß bestimmte Impulslängen garantiert werden können. Man hat auch versucht, auf der Ausgangsseite einen Verstärker nachzuschalten. Derartige Schaltungen sind alle aufwendig und kostenintensiv.

Der Erfindung liegt die Aufgabe zugrunde, eine Optokoppleranordnung zu entwickeln, die einfach aufgebaut ist, und bei der man die geschilderten Nachteile vermeidet.

Die Lösung der geschilderten Aufgabe besteht in einer Optokoppleranordnung nach Anspruch 1. Hierbei wird der Spannungsfall an einem weiteren Optokoppler in Serie gebildet, wobei der Optokoppler und der weitere Optokoppler auf der Eingangsseite in einem Schaltkreis angeordnet sind, der über eine Kapazität zur Ansteuerung, Ansteuerkapazität genannt, an einem Eingangsanschluß angeschlossen ist, wobei zwischen dem Optokoppler eine Leitungsverbindung zu einem weiteren Eingangsanschluß hergestellt ist. Auf der Ausgangsseite ist zwischen den Optokopplern eine Leitungsverbindung zu einem Ausgangsanschluß hergestellt. Die Serienschaltung aus den beiden Optokopplern ist ausgangsseitig an einer Seite an dem weiteren Ausgangsanschluß angeschlossen und an ihrer anderen Seite mit einer Versorgungsspannung verbunden. Man kommt mit gewöhnlichen preiswerten Optokopplern in der Serienschaltung aus, so daß sich die bisher erforderlichen teuren Optokoppler erübrigen. Die Ansteuerung der beiden Optokoppler erfolgt durch die Aufladung bzw. Entladung der Ansteuerkapazität. Einschaltzeit und Ausschaltzeit können dadurch sehr kurz und auch gleich lang eingestellt werden, da beide Zeiten durch das Einschalten eines Optokopplers gebildet werden. Ein Laststrom an einem Arbeitswiderstand erübrigt sich hierbei. Der Spannungsfall zur Bildung der Impulse wird jetzt an jeweils einem der Optokoppler in Serie gebildet.

Wenn man zur Ansteuerkapazität einen Widerstand parallel schaltet, wird ein kleiner Gleichstrom während eines Impulses mit übertragen. Dadurch wird sichergestellt, daß auch bei Leckströmen in der Schaltung ein Zustand "Spannung" oder "Keine Spannung", also "High" bzw. "Low" beibehalten werden kann.

Es ist auch günstig, in den weiteren Eingangsschluß einen weiteren Widerstand einzuschalten. Hierdurch läßt sich die Zeitkonstante für die Aufladung und für die Entladung der Ansteuerkapazität einstellen. Dadurch kann man die Stromflußzeit in der Ansteuerung der Optokoppler mittels der Zeitkonstanten Tau als Produkt aus Ansteuerkapazität und dem weiteren Widerstand optimal einstellen.

Die Erfindung soll nun anhand von in der Zeichnung grob schematisch wiedergegebenen Ausführungsbeispielen näher erläutert werden:

In FIG 1 ist das Prinzip einer bekannten Schaltung mit einem Arbeitswiderstand R1 dargestellt.

In FIG 2 ist eine bekannte invertierende Schaltung unter Einsatz eines Arbeitswiderstandes R2 dargestellt.

In FIG 3 ist ein erstes erfindungsgemäßes Ausführungsbeispiel für eine Optokoppleranordnung veranschaulicht. Es sind die Strompfeile für den Einschaltvorgang eingetragen.

In FIG 4 sind für die Optokoppleranordnung nach FIG 3 die Strompfeile für einen Ausschaltvorgang eingetragen.

In FIG 5 sind anhand einer Weiterbildung der Schaltungsanordnung nach FIG 3 bzw. FIG 4 die Strompfeile für den Einschaltvorgang wiedergegeben.

In FIG 6 sind anhand der Weiterbildung nach FIG 5 die Strompfeile für den Ausschaltvorgang eingetragen.

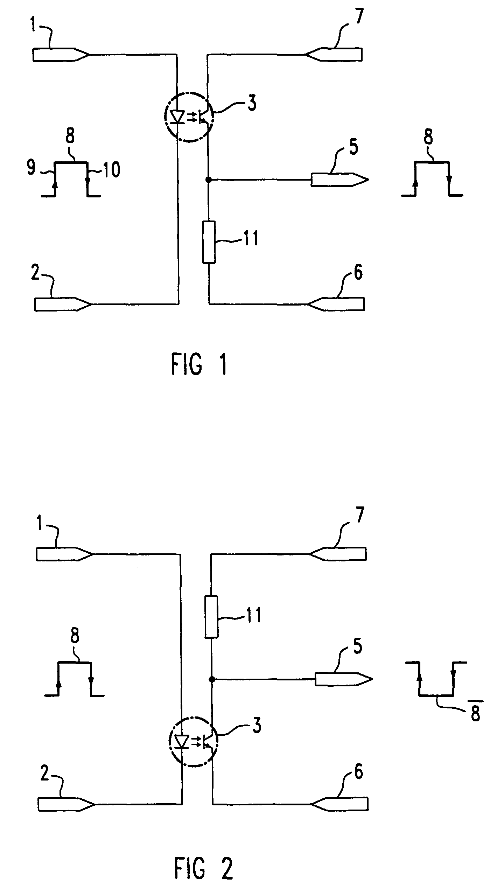

Bei einer bekannten Optokoppleranordnung nach den FIG 1 und 2 ist auf einer Eingangsseite zwischen einem Eingangsanschluß 1 und einem weiteren Eingangsanschluß 2 ein Optokoppler 3 angeordnet. Auf der Ausgangsseite besteht ein Ausgangsanschluß 5 und ein weiterer Ausgangsanschluß 6, am Anschluß 7 ist Versorgungsspannung angeschlossen. Im Beispiel ist der weitere Ausgangsanschluß 6 an Erde gelegt. Wenn zwischen den Eingangsanschlüssen 1 und 2 ein Impuls 8 mit der Anstiegsflanke 9 und der Abstiegsflanke 10 zugeführt wird, überträgt der Optokoppler das Signal, so daß die Ausgangsseite zwischen den Ausgangsanschlüssen 7 und 5 elektrisch leitend wird. Die Versorgungsspannung am Ausgangsanschluß 7 steht dann am Ausgangsanschluß 5 an. Diese Spannung steht über den Spannungsfall am Widerstand 11 ausgangsseitig gegen Erde an. Der übertragene Impuls 8 ist auf der Ausgangsseite dargestellt. Die Schaltungsanordnung nach FIG 2 arbeitet ersichtlich als inverse Schaltung, so daß der Impuls 8 in einem inversen Impuls $\bar{8}$ abgebildet wird.

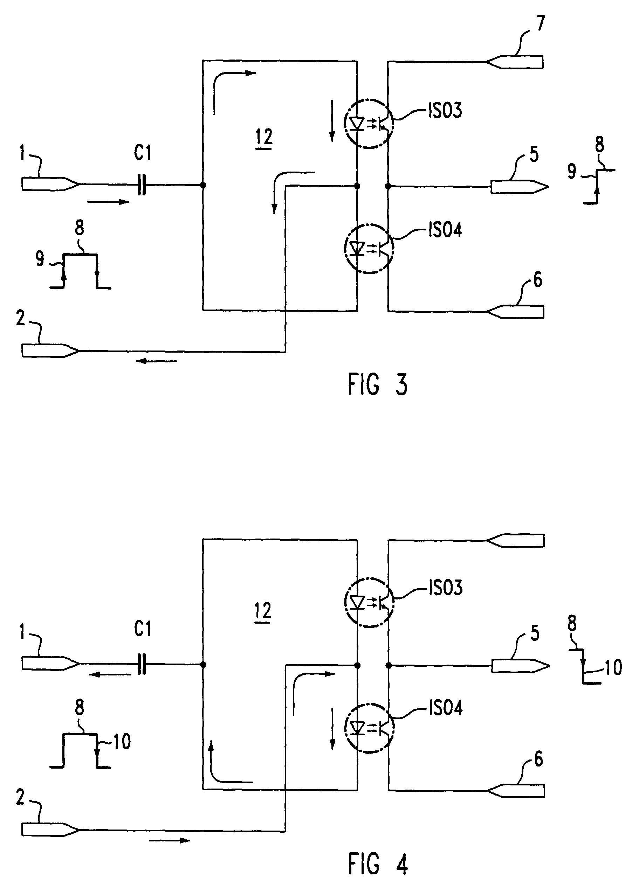

Erfindungsgemäß wird im Ausführungsbeispiel nach FIG 3 mit Optokopplern ISO 3 und ISO 4 in einer Serienschaltung gearbeitet, wobei vorzugsweise die Optokoppler gleiche Werte aufweisen. Im Vergleich zu FIG 1 wird der Spannungsfall an einem weiteren Optokoppler ISO 4 in Serie gebildet, wobei der Optokoppler ISO 3 und der weitere Optokoppler ISO 4 auf der Eingangsseite in einem Schaltkreis 12 angeordnet sind, der über eine Ansteuerkapazität C1 an einem Eingangsanschluß 1 angeschlossen ist. Zwischen den Optokopplern ist eine Leitungsverbindung zu einem weiteren Eingangsanschluß 2 hergestellt. Auf der Ausgangsseite ist zwischen den Optokopplern eine Leitungsverbindung zu einem Ausgangsanschluß 5 hergestellt. Die Serienschaltung aus den beiden Optokopplern ISO 3 und ISO 4 ist an einer Seite an den weiteren Ausgangsanschluß 6 angeschlossen. An ihrer anderer Seite steht sie mit dem Ausgangsanschluß 7 mit einer Versorgungsspannung in Verbindung.

Für den Einschaltvorgang sind in FIG 3 die Strompfeile eingetragen. Hierbei lädt sich die Ansteuerkapazität C1 auf, der Optokoppler ISO 3 wird leitend und der Optokoppler ISO 4 befindet sich im Sperrzustand. Auf die Ausgangsseite wird daher eine Anstiegsflanke 9 des Impulses 8 übertragen. Für einen symmetrischen Impuls empfehlen sich Optokoppler mit gleichen Daten.

Wenn der Impuls 8 auf der Eingangsseite an seiner Abstiegsflanke 10 angelangt ist, entlädt sich der Ansteuerkondensator C1, und an den Optokoppler ISO 3 gelangt, bezogen auf den Eingangsanschluß 2, negatives Potential, so daß er sperrt. Dem Optokoppler ISO 4 wird dieses Bezugspotential am Eingangsanschluß 2 und das negative Potential vom sich entladenden Ansteuerungskondensator C1 so zugeführt, daß er in den leitenden und emittierenden Zustand überführt wird. Entsprechend wird auf der Ausgangsseite der Ausgangsanschluß 5 auf das Potential des weiteren Ausgangsanschlusses 6 gelegt, hier Erde, so daß die Abstiegsflanke 10 des Impulses 8 übertragen wird, wie es in FIG 4 veranschaulicht ist.

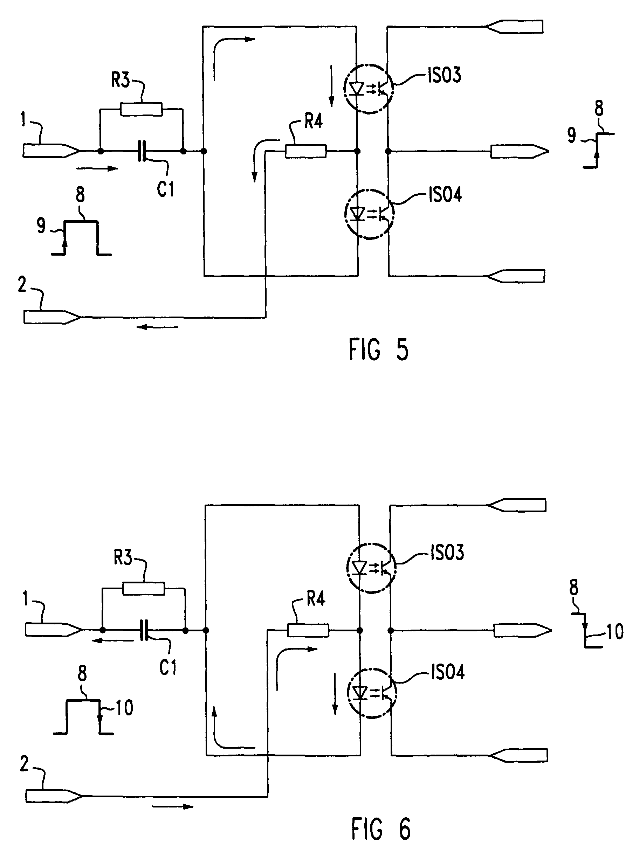

Im Ausführungsbeispiel nach FIG 5 ist zur Ansteuerkapazität C1 ein Widerstand R3 parallel geschaltet, um einen kleinen Gleichstromanteil zu übertragen, der Verluste ausgleichen kann, so daß die Impulse auch bei Verlusten ordnungsgemäß stehenbleiben. In den weiteren Eingangsanschluß ist ein weiterer Widerstand R4 eingeschaltet, der darauf abgestimmt ist, in Verbindung mit der Ansteuerkapazität C1 eine geeignete Zeitkonstante Tau für die Aufladung und Entladung der Ansteuerkapazität C1 einzustellen. Es gilt dann die Beziehung Tau = C1xR4 .

Verständlicherweise kann auch eine der Maßnahmen, Einschaltung des Widerstandes R3 bzw. Einschaltung des Widerstandes R4, ohne die andere Maßnahme vorgenommen werden.

In FIG 6 ist anhand einer Schaltung nach FIG 5 der Ausschaltvorgang und anhand der zugeordneten Strompfeile veranschaulicht.

Die Schaltungen eignen sich besonders zur Integration in einem Chip.

## Patentansprüche

1. Optokoppleranordnung zur Impulsübertragung bei galvanischer Trennung, die in einem Schaltnetzwerk je Übertragungsbereich zumindest einen Optokoppler auf einer Eingangsseite zum Impulsempfang aufweist, und die auf ihrer Ausgangsseite zur Impulsabgabe dem Prinzip nach mit einem Spannungsfall in Serie zum Optokoppler arbeitet, **dadurch gekennzeichnet,** daß der Spannungsfall an einem weiteren Optokoppler (ISO 4) in Serie gebildet ist, wobei der Optokoppler (ISO 3) und der weitere Optokoppler (ISO 4) auf der Eingangsseite in einem Schaltkreis (12) angeordnet sind, der über eine Kapazität (C1) zur Ansteuerung, Ansteuerkapazität genannt, an einem Eingangsanschluß (1) angeschlossen ist, wobei zwischen den Optokopplern eine Leitungsverbindung zu einem weiteren Eingangsanschluß (2) hergestellt ist, und wobei auf der Ausgangsseite zwischen den Optokopplern eine Leitungsverbindung zu einem Ausgangsanschluß (5) hergestellt ist und die Serienschaltung aus den beiden Optokopplern an einer Seite an einem weiteren Ausgangsanschluß (6) angeschlossen ist und an ihrer anderen Seite mit einer Versorgungsspannung in Verbindung steht (Anschluß 7).

2. Optokoppleranordnung nach Anspruch 1, **dadurch gekennzeichnet,** daß zur Ansteuerkapazität (C1) ein Widerstand (R3) parallel geschaltet ist.

3. Optokoppleranordnung nach Anspruch 2, **dadurch gekennzeichnet,** daß in den weiteren Einganganschluß (2) ein weiterer Widerstand (R4) eingeschaltet ist.

4. Optokoppleranordnung nach Anspruch 2, **dadurch gekennzeichnet,** daß der Widerstand (R3) darauf abgestimmt ist, daß ein kleiner Gleichstrom Verlustströme deckt.

5. Optokoppleranordnung nach Anspruch 3, **dadurch gekennzeichnet,** daß der weitere Widerstand (R4) darauf abgestimmt ist, daß in Verbindung mit der Ansteuerkapazität (C1) eine geeignete Zeitkonstante (Tau) für die Aufladung und Entladung der Ansteuerkapazität (C1)entsteht, im Sinne eines gewünschten Stromflußwinkels gemäß der Beziehung

Tau = C1xR4 .

FIG 1

FIG 2

FIG 3

FIG 4

FIG 5

FIG 6

**Europäisches Patentamt**

## EUROPÄISCHER RECHERCHENBERICHT

Nummer der Anmeldung

EP 97 10 2092

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | PATENT ABSTRACTS OF JAPAN vol. 014, no. 288 (E-0943), 21.Juni 1990 & JP 02 092044 A (MITSUBISHI ELECTRIC CORP), 30.März 1990, * Zusammenfassung * | 1-5 | H03K17/795 |

RECHERCHIERTE SACHGEBIETE (Int.Cl.6)

H03K

Der vorliegende Recherchenbericht wurde für alle Patentansprüche erstellt

| Recherchenort | Abschlußdatum der Recherche | Prüfer |
|---|---|---|
| DEN HAAG | 9.Juli 1998 | Cantarelli, R |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)